Europäisches Patentamt

European Patent Office

Office européen des brevets

(11) Publication number: **0 513 717 A1**

## (12) EUROPEAN PATENT APPLICATION

(21) Application number: **92107913.3**

(22) Date of filing: **11.05.92**

(51) Int. Cl.5: **G11C 19/28**, H04N 5/335

(30) Priority: **14.05.91 JP 138511/91**

(43) Date of publication of application:
**19.11.92 Bulletin 92/47**

(84) Designated Contracting States:
**DE FR GB**

(71) Applicant: **SONY CORPORATION**
**7-35, Kitashinagawa 6-chome Shinagawa-ku**
**Tokyo(JP)**

(72) Inventor: **Nakamura, Satoshi**
**c/o Sony Corporation, 7-35 Kitashinagawa**
**6-chome**
**Shinagawa-ku, Tokyo(JP)**

(74) Representative: **TER MEER - MÜLLER -**
**STEINMEISTER & PARTNER**
**Mauerkircherstrasse 45**
**W-8000 München 80(DE)**

(54) **Two-phase drive circuit for solid state imaging device.**

(57) A two-phase driver circuit for a solid-state imaging device is provided with a resonance frequency setting circuit (4), e.g. a series resonance circuit, between the two input terminals (ØH1, ØH2) of the imaging device which are clocked in phase opposition. The resonance frequency setting circuit (4) is adjusted such that its resonance frequency is equal to the shift clock frequency. The driver circuit, though simple in construction, has a sharply reduced power consumption and prevents a low frequency component from being cut off from the clock waveform. The circuit can be tuned easily.

# FIG.1

## BACKGROUND OF THE INVENTION

The present invention relates to a two-phase drive circuit for driving a solid-state image sensor, and more specifically to a drive circuit for driving a charge transfer device having a $\pi$ type load capacitance, driven by two-phase clocks opposite in phase to each other.

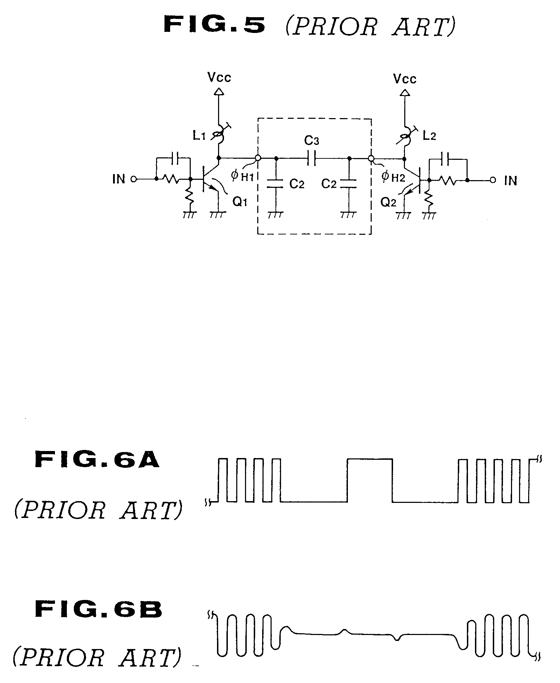

So far, the solid-state imaging device having a capacitive load has been driven simply by a driver having a low output impedance. However, the output impedance is not zero [$\Omega$], and a power P is consumed which is given by: $P = CV^2f$ where C is a load capacitance of the solid-state imaging device, V is an amplitude of the transfer clock pulses, and f is a driving frequency. In particular, the power consumption becomes very high as the number of pixels is increased to meet the demand in recent years. To decrease the power consumption and the operating voltage, there has been proposed recently a so-called switching resonance driver circuit (as disclosed in *Showa 63 Nen Denshi Joho Tsushin Gakkai Ronbunshu*, page 128). Fig. 5 shows a switching resonant drive circuit of this conventional example. In Fig. 5, a block of a broken line represents a capacitive load consisting of two electrode capacitances $C_2$, $C_2$ and a coupling capacitance $C_3$. This circuit further includes first and second transistors $Q_1$ and $Q_2$, and first and second inductors (or coils) $L_1$ and $L_2$. Each of the transistors $Q_1$ and $Q_2$ is connected between a unique one of two-phase input terminals $\phi_{H1}$ and $\phi_{H2}$ and a ground. Each of the inductors $L_1$ and $L_2$ is connected between a unique one of the input terminals $\phi_{H1}$ and $\phi_{H2}$, and a power source Vcc. The transistors $Q_1$ and $Q_2$ repeat on/off operations at the horizontal driving frequency. The circuit of $L_1$ and $C_2$, and the circuit of $L_2$ and $C_2$ are tuned to resonance at the driving frequency by adjusting the inductances of the inductors $L_1$ and $L_2$.

Although this conventional configuration is effective in reducing the power consumption and lowering the operating voltage, it is not appropriate for all solid-state image sensors. For example, some solid state image sensors are provided with two horizontal shift registers in order to lower the frequency of the transfer clock. The image sensors of this type requires modulation of the transfer clock pulses during the blanking period, to transfer the signal charge between the two horizontal shift registers. The conventional circuit, however, provides a transfer drive waveform shown in Fig. 6B, in contrast with a driver input waveform shown in Fig. 6A. As shown in Fig. 6B, a low frequency waveform (a clock waveform for transfer between the two horizontal shift registers) is cut off, so that this conventional circuit as such is incompetent for the transfer of the signal charge between the horizontal shift registers. Therefore, one or more complicated circuit must be added in order to be suitable for the transfer between the two horizontal shift registers. Moreover, the conventional circuit requires tuning of the two separate coils $L_1$ and $L_2$, so that the troublesome tuning operations are required to ensure proper performance notwithstanding the nonuniformity of the load capacitance.

## SUMMARY OF THE INVENTION

It is therefore an object of the present invention to provide a two-phase imager driving circuit which is very simple in circuit configuration, capable of reducing the power consumption sharply and preventing low frequency components from being cut off from the clock pulse trains, and easy to tune.

According to the present invention, a two-phase drive circuit for a solid-state image sensing device having first and second input terminals which, respectively, receives shift clock pulse trains which are in phase opposition to each other, is provided with a resonance frequency setting circuit which is connected between the first and second input terminals, and which is adjusted to make a resonance frequency of loads of drive stages, equal to the shift clock frequency. In one embodiment of the present invention, the resonance frequency setting circuit comprises a series circuit between the first and second input terminals.

In the two-phase drive circuit of the present invention, there is formed an antiresonance circuit which acts to trap the power consumption at the shift clock frequency. Therefore, the drive circuit of the present invention can reduce the power consumption greatly, and make it possible to transfer signal change between two horizontal shift registers by utilizing low-frequency pulses as well as the clock pulses.

## BRIEF DESCRIPTION OF THE DRAWINGS

Fig. 1 is a circuit diagram for showing one embodiment of the present invention.

Figs 2A and 2B are views showing a driver input waveform and a transfer drive waveform in the circuit shown in Fig. 1.

Fig. 3 is a graph showing an amplitude ($|V01|$) - frequency characteristic of the embodiment of the present invention..

Fig. 4 is a graph showing a power ($P_T$) - frequency characteristic of the embodiment of the present invention.

Fig. 5 is a circuit diagram showing a conventional example.

Figs. 6A and 6B are views showing a driver input waveform and a transfer drive waveform in the conventional driver circuit shown in Fig. 5.

## DETAILED DESCRIPTION OF THE INVENTION

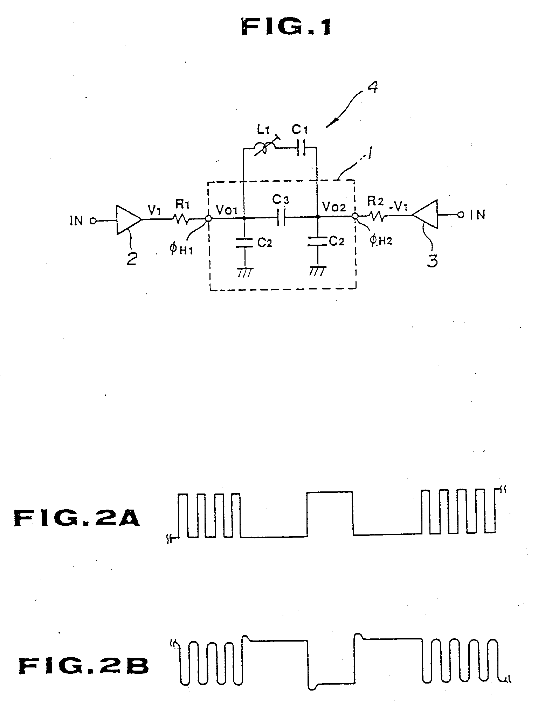

One embodiment of the present invention is shown in Fig. 1. A CCD driving circuit shown in Fig. 1 includes a capacitive load 1 composed of electrode capacitances (capacitances of adjacent gate electrodes of a charge transfer section (CCD) with respect to a ground) $C_2$ and $C_2$, and a coupling capacitance $C_3$ as in the conventional circuit. Terminals $\phi_{H1}$ and $\phi_{H2}$ are two-phase input terminals of the CCD (a horizontal shift register for an image sensor, for example) having this load capacitance 1. A driver input signal having a waveform shown in Fig. 2A is applied through an inverting driver 2 or 3 and a resistor $R_1$ or $R_2$, to each of the input terminals $\phi_{H1}$ and $\phi_{H2}$ as a shift drive signal having a waveform shown in Fig. 2B.

This CCD drive circuit further includes a series resonance circuit 4 which is composed of a coil $L_1$ and a capacitor $C_1$ and which is connected between the input terminals $\phi_{H1}$ and $\phi_{H2}$. Therefore, the CCD load as viewed from the driver is in the form of a parallel resonance (antiresonance) configuration. For simplicity of the explanation, the interconnection pattern resistance within the CCD is regarded as zero, and the load is a type having the capacitances $C_1$, $C_2$ and $C_3$ connected in a $\pi$ configuration. In Fig. 1, $R_1$, $R_2$ ($=R$) are output resistances of the drivers, $V_1$, $-V_1$ are two-phase outputs of the drivers 2 and 3, and $V_{01}$, $V_{02}$ are input terminal voltages of the CCD.

In this system, a power consumption P and the CCD input voltage $V_{01}$ are determined as follows. A current $I_{01}$ coming from the first input terminal $\phi_{H1}$ ($V_{01}$) and a current $I_{02}$ flowing out through the second input terminal $\phi_{H2}$ ($V_{02}$) are given by the following equations (1) and (2).

$$I_{01} = (V_1 - V_{01})/R$$
$$= j\omega C_2 V_{01} + (V_{01} - V_{02}) \times \{1/(j\omega L_1 + 1/j\omega C_1) + j\omega C_3\} \qquad (1)$$

$$I_{02} = (V_{02} + V_1)/R$$
$$= -j\omega C_2 V_{02} + (V_{01} - V_{02}) \times \{1/(j\omega L_1 + 1/j\omega C_1) + j\omega C_3\} \qquad (2)$$

From the equations (1) and (2);

$$(V_{01} + V_{02}) \times (1/R + jC_2) = 0$$
$$\therefore V_{02} = -V_{01} \qquad (3)$$

Substitution of the equation (3) into the equation (1) yields;

$$(V_1 - V_{01})/R = j\omega C_2 V_{01} + 2V_{01} \times \{1/(j\omega L_1 + 1/j\omega C_1) + j\omega C_3\}$$

Solving and rearranging this equation yields;

$$V_{01} = \frac{\left\{1 - \dfrac{\omega^2}{\omega_T^2} \times (1 + \dfrac{2C_1}{C_2 + 2C_3})\right\} \times V_1}{\left\{1 - \dfrac{\omega^2}{\omega_T^2} \times \left(1 + \dfrac{2C_1}{C_2 + 2C_3}\right)\right\} + j\omega R \times (2C_1 + C_2 + 2C_3) \times \left(1 - \dfrac{\omega^2}{\omega_T^2}\right)}$$

$$\cdots(4)$$

$$\therefore |V_{01}| = \frac{\left|1 - \dfrac{\omega^2}{\omega_T^2} \times (1 + \dfrac{2C_1}{C_2 + 2C_3})\right| \times |V_1|}{\sqrt{\left\{1 - \dfrac{\omega^2}{\omega_T^2} \times \left(1 + \dfrac{2C_1}{C_2 + 2C_3}\right)\right\}^2 + \left\{\omega R \times (2C_1 + C_2 + 2C_3) \times \left(1 - \dfrac{\omega^2}{\omega_T^2}\right)\right\}^2}}$$

$$\cdots(5)$$

In these equations,

$$\omega_T^2 = \frac{2C_1 + C_2 + 2C_3}{L_1 C_1 (C_2 + 2C_3)} \quad (\omega_T = 2\pi f_T)$$

$$\cdots(6)$$

Therefore,

$$I_{01} = \frac{V_1 - V_{01}}{R}$$

$$= \frac{V_1}{R} \times \left\{1 - \frac{1 - \dfrac{\omega^2}{\omega_T^2} \times (1 - \dfrac{2C_1}{C_2 + 2C_3})}{\left\{1 - \dfrac{\omega^2}{\omega_T^2} \times \left(1 + \dfrac{2C_1}{C_2 + 2C_3}\right)\right\} + j\omega R \times (2C_1 + C_2 + 2C_3) \times \left(1 - \dfrac{\omega^2}{\omega_T^2}\right)}\right\}$$

$$= \frac{j\omega R(2C_1 + C_2 + 2C_3) \times \left(1 - \dfrac{\omega^2}{\omega_T^2}\right)}{\left\{1 - \dfrac{\omega^2}{\omega_T^2} \times \left(1 + \dfrac{2C_1}{C_2 + 2C_3}\right)\right\} + j\omega R(2C_1 + C_2 + 2C_3) \times \left(1 - \dfrac{\omega^2}{\omega_T^2}\right)} \times \frac{V_1}{R}$$

$$\cdots(7)$$

From the equation (7), the power consumption on the part of the $V_{01}$ is given by;

$$P_{01} = R\left\{V_1 \times \overline{I_{01}}\right\}$$

$$= \frac{R \times \left\{\omega \times (2C_1 + C_2 + 2C_3) \times \left(1 - \dfrac{\omega^2}{\omega T^2}\right)\right\}^2 \times |V_1|^2}{\left\{1 - \dfrac{\omega^2}{\omega T^2} \times \left(1 + \dfrac{2C_1}{C_2 + 2C_3}\right)\right\}^2 + \left\{\omega R \times (2C_1 + C_2 + 2C_3) \times \left(1 - \dfrac{\omega^2}{\omega T^2}\right)\right\}^2}$$

$$\cdots(8)$$

From similar calculation of the power consumption on the part of $V_{02}$, we obtain; $P_{02} = P_{01}$. Therefore, the power consumption $P_T$ of the whole of this system is given by;

$$P_T = P_{01} + P_{02}$$

$$= \frac{2R \times \left\{\omega \times (2C_1 + C_2 + 2C_3) \times \left(1 - \dfrac{\omega^2}{\omega T^2}\right)\right\}^2 \times |V_1|^2}{\left\{1 - \dfrac{\omega^2}{\omega T^2} \times \left(1 + \dfrac{2C_1}{C_2 + 2C_3}\right)\right\}^2 + \left\{\omega R \times (2C_1 + C_2 + 2C_3) \times \left(1 - \dfrac{\omega^2}{\omega T^2}\right)\right\}^2}$$

$$\cdots(9)$$

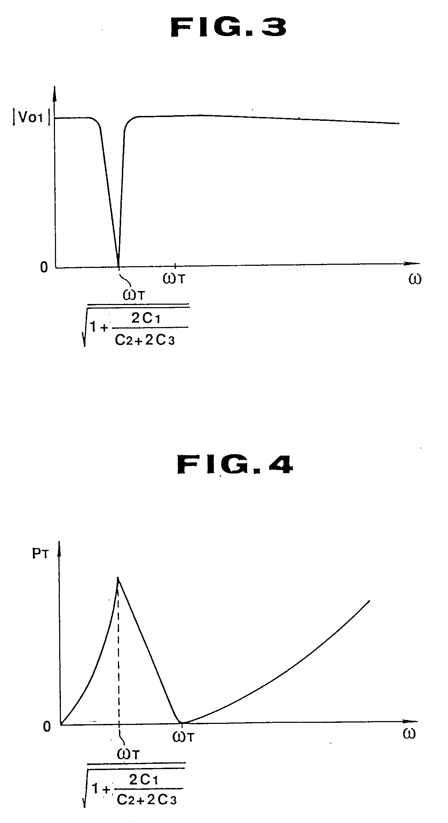

Figs. 3 and 4 show the equations (5) and (9) in graphical form. The curves of Figs. 3 and 4 are frequency characteristics of the amplitude $|V_{01}|$ and the power consumption $P_T$. As known from the equation (9), the power consumption is reduced to zero at $\omega = \omega_T$. Therefore, it is possible to reduce the power consumption drastically by choosing such values of the $L_1$ and $C_1$ as to satisfy the equation (6) specified by substituting the transfer frequency $\omega_T$ (angular frequency). That is, the inductor $L_1$ and the capacitor $C_1$ are so adjusted that the resonance frequency of the series resonance circuit 4 shown in Fig. 1 is put in agreement with the transfer frequency $\omega_T$ of the CCD. Under this condition, $|V_{01}| = |V_1|$, and the shift clock pulses are supplied to the CCD without suffering a decrease of the amplitude. The frequency characteristic is flat in a low frequency range as shown in Fig. 3, so that the modulation of the shift clock in the low frequency range is possible.

As explained above, in the two-phase circuit of the present invention for driving the solid-state image sensing device having two input terminals, the load of the drive stage is constituted by a parallel resonance circuit and its resonance frequency is made equal to the transfer clock frequency. Therefore, there is formed an antiresonance circuit which can trap the electric power at the clock frequency, so that the power consumption is reduced remarkably. The drive circuit of the present invention prevents the low frequency component from being cut off, so that the drive circuit enables the transfer of signal charge between two horizontal shift registers. Furthermore, it is possible to tune the drive circuit by adjusting only one component. In the present invention, the adjustment is very easy.

The resonance frequency setting circuit of the present invention may includes at least one adjustable (or variable) component. In the example shown in Fig. 1 in which the resonace frequency setting circuit is in the form of the LC series circuit, either or both of the inductor $L_1$ and the capacitor $C_1$ may be adjustable.

**Claims**

1. A two-phase drive circuit comprising:

   first and second input terminals (Ø H1, ØH2) to which shift clock pulses opposite in phase to each other are applied;

   a first drive stage (2) connected between said first input (ØH1) terminal and a first transfer electrode;

a second drive stage (3) connected between said second input (ØH2) terminal and a second transfer electrode;

a resonance frequency setting circuit (4) for making a parallel resonance frequency of loads of said first and second drive stages substantially equal to a clock frequency of said shift clock pulses, said resonance frequency setting circuit being connected in parallel with a coupling capacitor (1) between said first and second transfer electrodes.

2. A two-phase drive circuit according to claim 1, wherein said resonance frequency setting circuit (4) comprises a series circuit of a capacitor (C1) and an inductor (L1) for adjusting the parallel resonance frequency by varying an inductance of said inductor (L1).

3. A two-phase drive circuit according to Claim 1, wherein said resonance frequency setting circuit (4) comprises an inductor (L1) and a capacitor (C1) for adjusting the parallel resonance frequency by varying the capacitance of said capacitor (C1).

4. A two-phase drive circuit according to Claim 1, wherein said transfer electrodes are horizontal transfer electrodes of a charge transfer device.

5. A two-phase drive circuit according to Claim 1, wherein said first and second transfer electrodes are horizontal transfer electrodes of a horizontal shift register of a charge transfer device image sensor.

# FIG.1

# FIG.2A

# FIG.2B

# FIG. 3

# FIG. 4

# FIG.5 *(PRIOR ART)*

# FIG.6A
*(PRIOR ART)*

# FIG.6B
*(PRIOR ART)*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 014, no. 099 (E-0893)22 February 1990 & JP-A-01 303 758 ( HITACHI ) | 1,2 | G11C19/28 H04N5/335 |
| A | * abstract * | 3-5 | |
| | ----- | | |
| | | | **TECHNICAL FIELDS SEARCHED (Int. Cl.5)** |
| | | | G11C H04N |

The present search report has been drawn up for all claims

| Place of search | Date of completion of the search | Examiner |
|---|---|---|
| THE HAGUE | 20 AUGUST 1992 | LINDQUIST J.W. |

EPO FORM 1503 03.82 (P0401)